(19) Europäisches Patentamt

European Patent Office

Office européen des brevets

(11) **EP 0 973 043 A1**

(12) **EUROPEAN PATENT APPLICATION**

(43) Date of publication:
**19.01.2000  Bulletin 2000/03**

(51) Int. Cl.[7]: **G01R 33/60**

(21) Application number: **98810665.4**

(22) Date of filing: **13.07.1998**

(84) Designated Contracting States:
**AT BE CH CY DE DK ES FI FR GB GR IE IT LI LU MC NL PT SE**
Designated Extension States:
**AL LT LV MK RO SI**

(71) Applicant: **Newpharm & Trading SA**
**6918 Figino/Barbengo (CH)**

(72) Inventors:
• **Mashevsky, Alexander Alfredovich**
**BY-223053 Minsk (BY)**

• **Prokhorova, Violetta Igorevna**
**BY-220040 Minsk (BY)**
• **Muravsky, Vladimir Alexandrovich**
**BY-220040 Minsk (BY)**
• **Milyutin, Alexander Antonovich**
**BY-220040 Minsk (BY)**

(74) Representative:
**BOVARD AG - Patentanwälte**
**Optingenstrasse 16**
**3000 Bern 25 (CH)**

(54)   **Method of diagnosing malignant neoplasms based on ESR spectroscopy**

(57)   A method of diagnosing malignant neoplasms is described. The method of in vitro cancer diagnosis comprises ESR evaluation of physico-chemical parameters of mobility of the spin probe, made on the basis of long-chain fatty acids, immobilized into specific binding sites of serum albumin. The method is based on electron-spin-resonance spectroscopy ESR comprising the steps of

-   incubation of a serum probe of a patient with spin probe solution

-   recording an ESR spectrum at a constant temperature under conversion into a digital form
-   evaluating the digitalised spectrum by comparing it with a model spectrum.

Fig. 2

EP 0 973 043 A1

**Description**

The present invention is related to a method of diagnosing malignant neoplasms. The method of in vitro cancer diagnosis comprises ESR evaluation of physico-chemical parameters of mobility of the spin probe, made on the basis of long-chain fatty acid, immobilized into specific binding sites of serum albumin.

There are known biochemical, immuno-enzyme and physico-chemical laboratory methods of cancer diagnosis, which are based on determination of antigens, hormones, enzymes and other biologically active substances (tumor markers), which are either not found in biological samples taken from healthy persons, or a change in their content is detected in the samples of cancer patients.

The known tumor markers (TM) are highly specific only for certain types of malignant neoplasms (alpha-fetoprotein for hepatocellular cancer, non-seminomatous and embryonal testicular carcinoma; chorionic gonadotropin for epithelioma chorioepidermale; neuron-specific enolase for neuroblastomas; prostate-specific antigen for prostatic cancer and some others).

For instance, there is a method in which cancer is diagnosed by means of measuring the content of carcino-embryonic antigen (CEA) in blood. The techniques of immuno-enzyme tests or immuno-radiometric tests are used in this method [Titov V.N., Alyalyushkina V.A. Lactate dehydrogenase in the diagnosis of myocardial infarction: diagnostic and methodological aspects. *Laboratory Matters*, 1988, 11, 31-34. (Russian)].

For the known method the precision of diagnosis of colon cancer is 75%, gastric cancer - 45%, adenocarcinoma of the lung - 40%. However, rising of CEA titer also occurs in some cases of non-cancer diseases (inflammation, benign tumors), as well as in tobacco smokers and alcoholics.

Untill now, no TM is found, which is highly specific for all malignancies or their most common types. Moreover, the studies in the field of molecular oncology have established multiformity and heterogeneity of cellular malignant transformation mechanisms. From where it follows that efficient cancer diagnosis can only be provided by either a complex study of the whole set of TM, which is infeasible because of their plurality, or by evaluation of the functional state and the course of those molecular and metabolic processes in the human body which are modified in a similar way in the case of cancer pathology of various organs.

The transport system of biologically active substances in blood can be considered as one of such metabolic processes, as the uncontrolled growth of a malignant tumor requires significant amounts of structure-forming substrates, on the one hand, and on the other - detoxication of endotoxins originating in the course of tumor growth. These developments are characteristic for a tumor host in all the cases of cancer.

Serum albumin (SA) is known to be the main blood transport system, which provides transport of fatty acids, tryptophan, bilirubin, calcium, steroid hormones and other functionally important substances to target cells, and also participates in binding and disposing of numerous toxins, among them those of endogenic origin.

It is also known that metabolites, for example of endogenic origin, are able to cause conformation modification of SA molecules [Tolkachyova N.V., Levachyov M. M., Medvedev F. A. Transport of fatty acids and products of their peroxidation by serum albumin in cases of ischemic and non-coronagenic damage of the cardiac muscle. *Issues of Medical Chemistry*, 1989, 2, 89-92. (Russian); Sorkina D.A., Zalevskaya I.N. Structural and functional properties of proteins: An educational manual. Kiev, 1990. (Russian)], affecting their functional state and SA transport system as a whole. Under development of the pathology, integration of SA with metabolic products results in redistribution of its factions, moreover the total albumin amount is frequently unchanged. Such structural variability of SA (transient multialbuminemia) is observed in cancer diseases.

Modification of the functional state of SA molecules can be detected and evaluated by the variation in the parameters of binding of certain substrates by albumin.

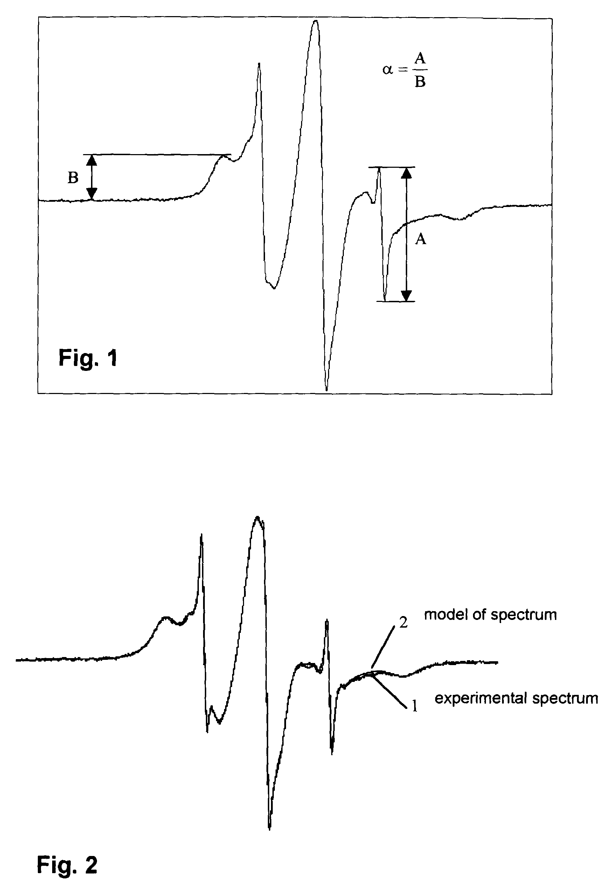

The method of cancer diagnosis in vitro [USSR Invention Certificate SU 1319705] includes ESR estimation of physico-chemical parameters of spin probe binding in serum or plasma of blood. Then the characteristics of spin probe binding ($\alpha$) is estimated alone as the ratio of amplitudes of two peaks in the registered ESR spectrum of spin probe (c.f the appended Fig. 1). According to that method cancer is diagnosed if the value of the factor of binding $\alpha$ is more than 1.

Depending on the type of the spin probe, by the known method it is possible to investigate various blood components in compliance with the peculiarity of the spin probe binding (SA, lipoproteins, sex-steroid-transport proteins, thyroxin-binding proteins, etc.).

However, in these cases the information content of the probe binding's estimation by the ratio of A and B peaks' values of two lines in ESR spectrum, as it is done in the known method, is insufficient. For instance, fatty acids are bound in blood serum by specific binding sites of various types, which considerably differ in their parameters, although being located on SA molecules. Accordingly, the ESR spectrum of spin-labeled fatty acid, bounded with SA, presents a superposition of several spectral lines from different ESR spectra (spectral components) corresponding to various types of binding sites and the spectral lines of these components are overlapping. Variation of the probe mobility, occurring in various binding sites in different ways, brings about an intricate alteration in the total ESR spectrum. It is obvious that in this case the spin probe mobility cannot be estimated by one parameter. There is a similar situation for a number of other spin probes.

For this reason, the precision of cancer diagnosis by means of the known method is low for many types of cancer. The inventors of the present application made a wide verifying investigation of this method which demonstrated that the false-positive and false-negative results of cancer diagnosis exceeds 30% for cancer of the internal and of external sites, as well as for early stages of the disease.

In the above mentioned method a paramagnetic probe is injected and the binding value is measured at room temperature. As described the method does not secure a sufficient diagnostic sensitivity, neither does it give a complete idea of conformational diagnostic properties of serum albumin.

The object of the present invention consists in providing a method having a highly improved precision and sensitivity in the diagnosis of cancer as malignant neoplasms.

It was found that the evaluation of the complete information of ESR spectra is the key to a more reliable diagnosis of cancer than with the evaluation of the ratio of the amplitudes of two peaks.

The subject of the present invention is the method according to the definition in the appended claims.

A remarkable increase of the precision of cancer diagnosis by ESR spectroscopy of serum of a patient (Serum albumin, SA) can be achieved according to the present invention in the following way.

In an in vitro cancer diagnosis method comprising ESR evaluation of physico-chemical parameters of mobility of spin probe, made on the basis of long-chain fatty acid, immobilized into specific binding sites of serum albumin, the probe mobility in SA binding sites is evaluated separately for three types of binding centers, in which discovering of the interrelated variations in probe mobility parameters indicate the presence of cancer-specific reduction in conformation mobility of SA, and cancer is diagnosed if such reduction is detected.

For carrying out a typical embodiment of the method according to the invention, the following is needed:

- ESR spectrometer adapted for assaying of biological fluids, which provides maintenance of stable temperature of the assays, digitizing of the measured ESR spectra and entering them into the computer;
- a computer program for calculation of the parameters of spin probe's ESR spectra;
- spin probe - 16-doxyl-stearic acid (16-DS) which is spin-labeled stearic acid;
- standard clinical equipment applied in clinical microanalysis.

The purpose of developing a highly effective method of cancer diagnosis is achieved in the following way. The value of discriminant function is determined on the basis of complex evaluation of physico-chemical parameters of mobility of spin-labeled fatty acid immobilized in specific sites of serum albumin binding, using original mathematical programs specially produced for this aim. If the value of discriminant function exceeds 1.0, a malignant neoplasm is diagnosed (lung cancer, gastric cancer, colon cancer). The diagnostic efficiency of the methods is over 85 %.

The method is realized in the following way: 10 $\mu$l of paramagnetic probe at the concentration of $10^{-2}$ mol/l are added to 50 $\mu$l of blood serum and injected into the cell of ESR-analyzer

PS-100X at the temperature of 37 °C in the resonator; then mathematical processing and analysis of spin probe spectra is performed by means of the spectrum observed and mathematical programs available. 16-doxyl-stearate (16-DS) was used as a spin probe to study the conformational dynamic properties of albumin.

The figure presents statistical distribution of discriminant function for a diagnostic set of parameters of albumin conformational dynamic mobility. As abscissa, the values of discriminant function, as ordinate, relative rate of value occurrence.

The equipment listed below is typical for carrying out the method of the present invention:

- ESR analyzer PS 100X.
- Laboratory centrifuge
- Micro-measuring hoppers for 1.0 ml; 0.01 ml; 0.05 ml.
- Centrifuge test-tubes.
- capillary tubes for test system.
- Test-tube racks.
- Spot plates of immunology type.
- Microanalytical scales.

The reagents listed below are typical for carrying out the method of the present invention:

- 16-doxyl-stearic acid spin label.
- rectified alcohol purified by phenylhydrazine and sulfuric acid (twice distilled).
- Solution of a spin probe. It must be preserved in hermetically closed test tubes in a refrigerator with the temperature of -20 °C.

- 40 g/l human blood serum fat-free albumin prepared on isotonic sodium chloride. The temperature is maintained at + 4 °C.
- Isotonic sodium chloride solution (0.9 g. of NaCl per 0.1 litre of distilled water).

Typical procedure: 2 ml of blood taken on an empty stomach from the vein of a patient are gathered in a centrifuge test tube. (Patient must not receive any medicines the day before investigation.) Blood is centrifuged for 30 minutes at 1500 min$^{-1}$. Serum is taken in glass test tubes to preserve its biological properties for 5-7 days. At the same time albumin may be damaged in the case of freezing. 50 μl of serum are put into a well of a microtiter plate ot the like. Then 10 μl of probe solution are added and mixed carefully. Mixture from the well is gathered in the capillary tube for ESR analysis and it is put into the spectrometer.

The registitration and processing of the ESR spectra in the method according to the present invention are normally carried out automatically.

Investigation errors may be caused by following:

- Insufficient quality of albumin (purity and stability) for probe calibration.
- Errors of probe weighing. In order to weigh probe, only microanalytical scales (of VLR-20 type) must be used.
- Differences spin label activity in different lots. It is necessary to verify label's quality at the same sample in using coefficient correction.
- Certain changes in a spin label solution at storing. It's necessary to verify it regularly in using standard albumin.
- Insufficient precision of micro-measuring hoppers. These and microcapillary tubes for the test system must have only 0.5-1 % error.
- Insufficient accuracy of testing.

Precision of testing means the degree of replication of the test. This is the ability to give the same answer for the same sample when tested twice. Precision testing depends on the qualification of personnel making microanalyses in vitro as well as on the influence of external factors and the quality of equipment.

Evaluating test precision evaluation has to include an estimation of three parameters:

- Replication of standard calibration for different lots of reagents must have coefficient of variation (CV) < 2%.
- Replication within one testing (3-6 replicates) must have CV < 3-5%.
- Replication of the same control samples tested by different personal must have CV < 5% The method according to the invention enables results to be obtained with sufficient accuracy for the medical purposes (CV < 5-10%).

For carrying out the method according to the invention, an appropriate amount of spin probe solution is added to a serum sample separated from a blood sample with a laboratory centrifuge; incubation is performed preferably at about 37 °C for 10-20 min with continuous shaking.

After the incubation, the spin-labeled serum is put into a measuring cuvette which is placed in the measuring resonator of the ESR spectrometer, constant temperature being maintained at a constant temperature preferably at the level of about 37°C.

The ESR spectrum is recorded. The obtained spectrum is a superposition of particular spectra of the spin probe molecules immobilized into various specific sites of binding of long-chain fatty acids. These binding sites are located in the SA of the examined blood serum because long-chain fatty acids are bound mainly to serum albumin (SA) in blood serum.

Obtained in this way and digitized the ESR spectrum of the spin-labeled blood serum is entered into the computer to calculate parameters of spin probe mobility. This calculation is done separately for various binding sites.

The parameters evaluating spin probe mobility in specific binding sites of SA are calculated by means of ESR spectrum simulation, using for each spectrum component the spin model based on the Hamiltonian function with axial anisotropy.

Since the spin probe employed is stearic fatty acid, in the hydrocarbon chain's 16th position of which nitroxyl spin label is added Hamiltonian function {H} provides for two interactions: Sehemann interaction of an electron of the probe spin label with magnetic field of the ESR spectrometer and hyperfine interaction of this electron with the magnetic moment of nucleus of nitrogen incorporated in the nitroxyl spin label, and assumes the general form of

$$\{H\} = \beta \hat{S} \mathbf{g} \overline{H} + \hat{I} \mathbf{a} \hat{S} , \qquad (1)$$

where

**g** is the tensor of g-factors,
$\hat{S}$ is the operator of electron spin,
$\hat{I}$ is the nucleus spin operator,
**a** is the tensor of hyperfine interaction,
$\overline{H}$ is the magnetic field vector,
$\beta$ is the Bohr magneton.

Moreover, the spin probe on the basis of nitroxyl label belongs to axially symmetric paramagnetic systems having the symmetry axis C3 or C4. Therefore, for the elements of tensors **g** and **a** the equality is

$$g_{xx} = g_{yy}, \ a_{xx} = a_{yy}, \tag{2}$$

(symmetry axis is assumed to be collinear to z axis), and the spin Hamiltonian function assumes the form of

$$\{H\} = \beta S_z g_{zz} H_z + \beta g_{xx} (S_x H_x + S_y H_y) + I_z a_{zz} S_z + a_{xx} (I_x S_x + I_y S_y) \tag{3}$$

The expression for calculation of the resonance value of $H_r$ magnetic field, with which spin label resonance occurs at **v** frequency of electromagnetic microwave field, obtained from the solution of the Hamiltonian (3), assumes the form:

$$g\beta H_r = h\nu - Km - \frac{1}{2(h\nu - Km)} \left\{ \frac{(a_{zz}^2 - a_{xx}^2)^2}{4K^2} \left\{ \frac{g_{xx}g_{zz}}{g} \right\} \sin^2\theta \cdot m^2 + \frac{a_{xx}^2 (K^2 + a_{zz}^2)}{2K^2} \left[ I(I+1) - m^2 \right] \right\}, \tag{4}$$

where

$$g^2 = g_{zz}^2 \cos^2\theta + g_{xx}^2 \sin^2\theta,$$

$$K^2 = (a_{zz}^2 g_{zz}^2 \cos^2\theta + a_{xx}^2 g_{xx}^2 \sin^2\theta)/g^2,$$

I = nitrogen nucleus spin (I=1),
m = projection of nitrogen nucleus spin I to **z** axis (assumes the values of 1, 0, -1),
$\theta$ = angle between the direction of magnetic field and **z** axis,
h = Planck's constant,
v = resonance frequency of microwave field.

Probability of resonance transition of spin label's electron is calculated as

$$\langle W(\theta) \rangle = \beta^2 H_1^2 \frac{g_{xx}^2}{8} \left( 1 + \frac{g_{zz}^2}{g^2} \right), \tag{5}$$

where $H_1$ is the peak value of the magnetic component of microwave field.
Taking into account (4) and (5), the expression for calculation of I(H) shape of one ESR spectrum component corresponding to the signal of spin probe molecules immobilized into binding sites of the same kind, assumes the form:

$$I(H) = \int_0^\pi \left| \frac{\partial H_r}{\partial h\nu} \right| \langle W(\theta) \rangle Y(H - H_r(\theta), \theta) \sin\theta d\theta, \tag{6}$$

where integration with respect to θ is used to sum over all possible orientations of spin probe molecules,

$$Y(H\text{-}H_r,\theta) = \text{function of shape of spectral line,}$$

$$\left|\frac{\partial H_r}{\partial h\nu}\right| = \text{factor allowing for technique of ESR spectra registration by means of scanning the magnetic field instead of microwave frequency.}$$

The initial shape of a spectral line (corresponding to "pure" resonance without taking into consideration additional disturbances and lines spreading) is presented in the form of the Lorentz function:

$$L(H - H_r, \sigma) = \frac{1}{\pi\sigma} \cdot \frac{1}{1 + \frac{(H-H_r)^2}{\sigma^2}} \qquad (7)$$

where σ is the width of the spectral line, which depends on the orientation of molecules and assumes the following form for the main axes:

$$\sigma_i = \alpha_i + \beta_i m + \gamma_i m^2, \qquad (8)$$

where i = {x, y, z} denotes coordinate axis,

m = nucleus spin projection to **z** axis.

Angular dependence of σ width is calculated from the equation:

$$\sigma^2 = (\sigma_z^2 g_{zz}^2 \cos^2\theta + \sigma_x^2 g_{xx}^2 \sin^2\theta)/g^2. \qquad (9)$$

Substitution of (5), (7) and (9) in (6) enables to calculate the initial model I(H) ESR spectrum, which does not take into account spectral line spreading occurring in real studies due to the effect of local inner microfields in the sample and of inhomogeneities of outer fields used for registration of ESR signal.

Owing to the local inner effects and inhomogeneities of outer fields, each point of the initial ESR spectrum is spread by these disturbances to a Gauss curve.

Gaussian spreading of ESR spectrum shape is allowed for by means of an integral convolution:

$$I_g(H) = \int_{-\infty}^{+\infty} I(H_1) \frac{1}{\sigma_G \sqrt{2\pi}} e^{-\frac{(H-H_1)^2}{2\sigma_G^2}} dH_1, \qquad (10)$$

where $\sigma_G$ is parameter of Gaussian spreading.

Since in the ESR spectrometer for the ESR-signal measuring the modulation method is used, in which magnetic field is modulated as sine wave and the ESR signal is obtained by synchronous detection and recorded as the first derivative of the spectrum, the first derivative of Lorentz function (7) should be substituted in (6) as the initial shape of the spectrum line. Influence of modulation causes the spectral line's distortion, which is allowed for by the following integral convolution:

$$I_m = (H) = \frac{\int_{H-H_{mod}}^{H+H_{mod}} I_g(H_1) \sqrt{1-\left(\frac{H-H_1}{H_{mod}}\right)^2} dH_1}{\int_{H-H_{mod}}^{H+H_{mod}} \sqrt{1-\left(\frac{H-H_1}{H_{mod}}\right)^2} dH_1}, \qquad (11)$$

where $H_{mod}$ is the modulation peak value.

$I_m(H)$ ESR spectrum model shape obtained with the help of the described algorithm is used for simulation of experimental ESR spectra of spin-labeled blood serum. The values describing the parameters of spin probe mobility in SA binding centers are established by minimization of the square of the difference of modeled and experimentally measured ESR spectra.

To mathematically process the ESR spectrum of spin-labeled blood serum, we use a specially developed computer program implementing the described calculation algorithm. The time needed by a current personal computer (e.g. IBM-P166 type) to process one ESR spectrum does not exceed 1 min.

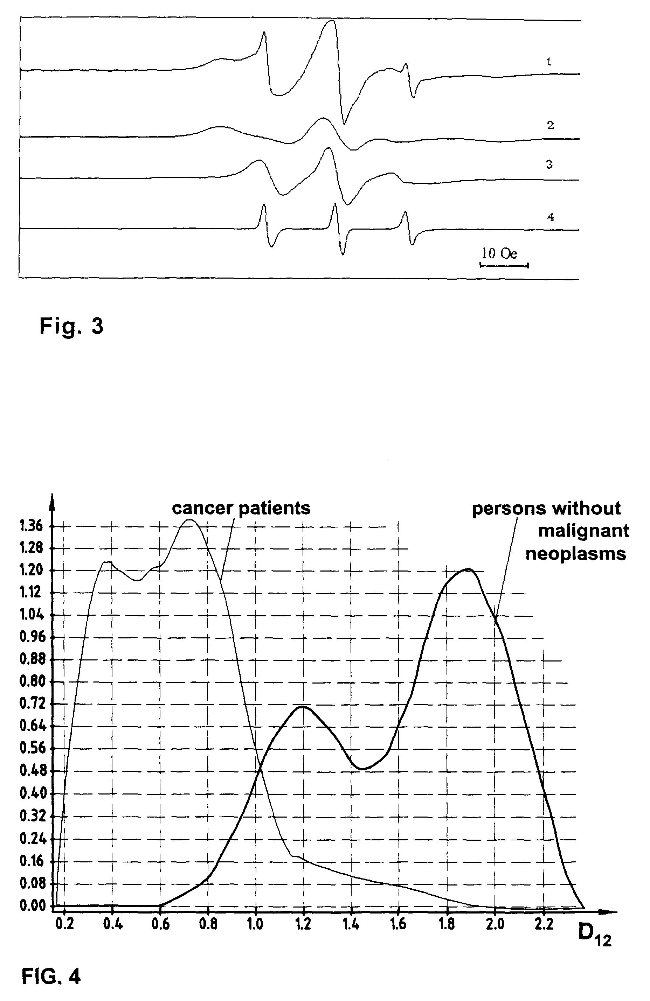

Fig. 2 presents as an example the results of mathematical processing of a typical ESR spectrum of spin-labeled blood serum: experimentally measured at 37 °C the spectrum of 16-DS spin probe incubated with blood serum in comparison with the modeled spectrum obtained by means of its simulation. Fig. 3 presents the modeled spectrum of spin-labeled blood serum and the three spectral components constituting it which correspond to the three types of sites of binding the spin probe in SA.

Fig. 3:

Spectrum of 16-DS immobilized on albumin at 37°C,
probe concentration $1.6 \cdot 10^{-3}$ mol,
albumin concentration $6 \cdot 10^{-4}$ mol

        1 - experimental spectrum,
        2 - first component,
        3 - second component,
        4 - third component

As a result of mathematical analysis of ESR spectrum, a set of evaluations of biophysical parameters of spin probe mobility in SA binding sites is obtained, which in a certain way characterize conformation mobility of SA molecules as shown in Table 1.

Table 1

| Parameters of 16-DS spin probe mobility, measured from ESR spectra, and their relationship with parameters of albumin conformation mobility | | |
|---|---|---|
| Parameter of spin probe mobility, measured from ESR spectrum | Units | Biophysical parameter of albumin conformation mobility |
| **The first component** | | **The first binding site** |
| 1. Relative probe concentration | Relative units | Specific capacity of probe binding site |
| 2. Isotropic g-factor | relative units | Integral parameter of site conformation |
| 3. Level of g-factor anisotropy | relative units | Parameter of spin probe microenvironment |
| 4. HFS isotropic constant | Oe | Parameter presenting the site size in inverse proportion |
| 5. Level of HFS anisotropy | relative units | Value proportional to the degree of spin probe order |
| 6. Width of low-field spectral line | Oe | Parameter of spin probe mobility |
| 7. Width of central spectral line | Oe | Parameter of spin probe mobility |
| 8. Width of high-field spectral line | Oe | Parameter of spin probe mobility |
| **The second component** | | **The second binding site** |
| 9. Relative probe concentration | relative units | Specific capacity of probe binding site |
| 10. Isotropic g-factor | relative units | Integral parameter of site conformation |
| 11. Level of g-factor anisotropy | relative units | Parameter of spin probe microenvironment |
| 12. HFS isotropic constant | Oe | Parameter presenting the site size in inverse proportion |
| 13. Level of HFS anisotropy | relative units | Value proportional to the degree of spin probe order |
| 14. Width of low-field spectral line | Oe | Parameter of spin probe mobility |
| 15. Width of central spectral line | Oe | Parameter of spin probe mobility |
| 16. Width of high-field spectral line | Oe | Parameter of spin probe mobility |

**Examples**

10 $\mu$l of $10^{-2}$ mol/l spin probe solution are added to 50 $\mu$l of serum separated from a blood sample with the help of a laboratory centrifuge; incubation is performed at 37 °C for 10-20 min with continuous shaking.

After the incubation, the spin-labeled serum is put into a measuring cuvette which is placed in the measuring resonator of the ESR spectrometer, constant temperature being maintained at the level of 37±0.2 °C.

ESR spectrum is recorded. The obtained spectrum is a superposition of particular spectra of the spin probe molecules immobilized into various specific sites of binding of long-chain fatty acids. These binding sites are located in the SA of the examined blood serum because long-chain fatty acids are bound mainly with serum albumin (SA) in blood serum.

Obtained in this way and digitized, the ESR spectrum of the spin-labeled blood serum is entered into the computer to calculate parameters of spin probe mobility. This calculation is done separately for various binding sites.

The parameters evaluating spin probe mobility in specific binding sites of SA are calculated by means of ESR spectrum simulation as described in the present description.

Table 2 demonstrates typical values of spin probe mobility parameters and typical values of errors in their measuring. We obtained the data when studying reproducibility of parameter for 300 blood serum samples.

Table 2

| Values of $\bar{x}_i$, $S_{oi}$, $\Delta_l$, and $\delta_l$ for parameters determined from spin-labeled 16-DS blood serum's ESR-spectra | | | | |
|---|---|---|---|---|
| **Parameter** | $\bar{x}_i$ | $S_{oi}$ | $\Delta_l$ | $\delta_l$ % |
| Concentration of probe in binding sites of the 1st type (the 1st component) | 0.601 | 1.82E-02 | 3.64E-02 | 6.1 |
| Concentration of probe in binding sites of the 2nd type (the 2nd component) | 0.388 | 1.87E-02 | 3.74E-02 | 9.6 |
| HFS isotropic constant, the 1st comp. | 16.2 | 7.34E-02 | 1.47E-01 | 0.9 |
| HFS isotropic constant, the 2nd comp. | 14.7 | 2.81E-02 | 5.62E-02 | 0.4 |
| HFS anisotropy, the 1st comp. | 1.27 | 8.29E-03 | 1.66E-02 | 1.3 |
| HFS anisotropy, the 2nd comp. | -0.122 | 2.46E-04 | 4.92E-04 | 0.4 |
| Width of high field line, the 1st comp. | 3.10 | 1.12E-01 | 2.25E-01 | 7.2 |
| Width of central line, the 1st comp. | 2.69 | 6.29E-02 | 1.26E-01 | 4.7 |
| Width of low-field line, the 1st comp. | 2.83 | 1.92E-01 | 3.84E-01 | 13 |
| Width of high field line, the 2nd comp. | 7.43 | 1.68E-01 | 3.36E-01 | 4.5 |
| Width of central line, the 2nd comp. | 3.21 | 3.15E-02 | 6.29E-02 | 2 |
| Width of low-field line, the 2nd comp. | 4.38 | 2.68E-02 | 5.36E-02 | 1.2 |
| G-factor anisotropy, the 1st comp. | -6.10E-04 | 6.06E-05 | 1.22E-04 | 20 |
| G-factor anisotropy, the 2nd comp. | 8.30E-05 | 8.26E-06 | 1.65E-05 | 20 |
| Isotropic g-factor, the 1st comp. | 2.00 | 1.67E-05 | 3.35E-05 | 0.002 |
| Isotropic g-factor, the 2nd comp. | 2.00 | 1.67E-05 | 3.35E-05 | 0.002 |
| Probe concentration in binding sites of the 3rd types (the 3rd comp.) | 9.71E-03 | 1.78E-03 | 3.56E-03 | 37 |

The data we have obtained in our extensive clinical studies including ESR test of 745 blood serum samples of lung cancer patients, 373 gastric cancer patients, 294 colon cancer patients, 28 esophageal cancer patients, 117 breast cancer patients, 479 patients with chronic non-malignant diseases of the same organs, 292 apparently healthy persons, indicate that patients with malignant neoplasms at various sites show specific interrelated variations of certain parameters of spin probe mobility in SA binding sites which is evidence of decrease in conformation mobility of SA molecules, whereas such variations of SA conformation mobility are not found in the blood of apparently healthy persons and patients with chronic non-malignant diseases.

Table 3 presents examples of measured parameters of 16-DS spin probe mobility in specific binding sites of SA in some patients with cancer of various sites and patients without malignant tumors:

**I. Cancer patients**

1. Patient G.A.A., study code 8606, 46 years.
Clinical diagnosis: carcinoma of the inferior-external quadrant of the right breast, T1N0M0.
Histological diagnosis: stage I infiltrative ductal carcinoma.
2. Patient T.A.I., study code 8615, 47 years.
Clinical diagnosis: cancer of the lower third of the esophagus, T2N2M0.
Histological diagnosis: well-differentiated squamous cell carcinoma.
3. Patient B.P.S., study code 8636, 52 years.
Clinical diagnosis: cancer of the left low lobe bronchus, T2N0M0G$_2$.
Histological diagnosis: moderately differentiated adenocarcinoma.

4. Patient R.S.I., study code 8640, 59 years.
Diagnosis made at clinico-instrumental examination: cancer of the stomach body, T3N2M0.
Histological diagnosis: signet-ring cell carcinoma.

**II. Patients without malignant tumors**

(employees of Research Institute of Oncology and Medical Radiology, Minsk)

1. Patient M.T.I., study code 8621, 42 years.
Diagnosis made at thorough physical and instrumental examination: left-side diffuse mastopathy. No malignant pathology is found.
2. Patient K.V.A., study code 8643, 20 years.
Apparently healthy. Complete outpatient examination revealed no pathology.
3. Patient V.N.A., study code 8649, 56 years.
Diagnosis made at physical, laboratory and instrumental examination:
chronic hepatocholecystitis. No malignant pathology.

Table 3

| Examples of measured parameters of 16-DS spin probe mobility in specific binding sites of SA in patients with cancer of various sites and patients without malignant tumors | | | | | | | | | |
|---|---|---|---|---|---|---|---|---|---|
| Study code | Parameters* of spin probe mobility in serum albumin binding sites | | | | | | | | |
| | Sites of the 1st type | | | Sites of the 2nd type | | | Sites of the 3rd type | | |
| | C | A | W | C | A | W | C | A | W |
| *Cancer patients:* | | | | | | | | | |
| 8606 | 0.511 | 16.27 | 2.53 | 0.466 | 14.84 | 3.15 | 0.019 | 15.51 | 0.81 |
| 8615 | 0.499 | 16.15 | 2.67 | 0.475 | 14.79 | 3.17 | 0.023 | 15.49 | 0.81 |
| 8636 | 0.493 | 16.22 | 2.68 | 0.486 | 14.81 | 3.13 | 0.018 | 15.45 | 0.81 |
| 8640 | 0.556 | 16.06 | 2.61 | 0.418 | 14.76 | 3.26 | 0.021 | 15.53 | 0.83 |
| *Patients without malignant tumors:* | | | | | | | | | |
| 8621 | 0.525 | 16.36 | 2.55 | 0.457 | 14.90 | 3.10 | 0.015 | 15.41 | 0.79 |
| 8643 | 0.556 | 16.26 | 2.52 | 0.427 | 14.87 | 3.17 | 0.013 | 15.46 | 0.85 |
| 8649 | 0.552 | 16.35 | 2.41 | 0.431 | 14.86 | 3.04 | 0.014 | 15.42 | 0.81 |

*)
C - Concentration of probe in binding sites,
A - HFS isotropic constant,
W - Width of central line

Table 3 demonstrates that spin probe mobility parameters are differing in all the three sites of SA binding in cancer patients. These differences undoubtedly indicate a decrease in conformation mobility of SA in cancer patients in comparison with the persons without malignant disease.

Each of the parameters presented in Table 3, taken separately, may be used as a diagnostic test for the presence of malignant neoplasm (just as it is in the known method). However, the diagnostic precision of such tests is low because the specific reduction in conformation mobility of SA in cancer patients manifests itself by alteration of various parameters: distribution of the probe in binding sites, alteration of binding sites' volumes, alteration of the mobility of probe molecules immobilized into binding sites. Being of the same direction, these alterations manifest themselves in different extent in separate parameters of spin probe mobility.

High precision of cancer diagnosis is secured only by joint evaluation of the set of parameters of probe mobility in SA binding sites.

For this purpose, the values of separate parameters are included in the common decision rule (discriminating function) which is constructed as a mathematical function integrating directed deviations in separate parameters. Such a function may be plotted by various methods: discriminating analysis, cluster or factor analysis, or by empirical method on the basis of analysis of the data obtained in clinical examinations.

The preferred function employed according to the present invention is plotted by means of quadratic discriminating analysis.

Logarithm of the quadratic discriminating function for the two compared groups of patients (cancer patients - patients without malignant tumors), which includes 4 parameters of spin probe mobility (probe concentration in the binding sites of the 1st type, probe concentration in the binding sites of the 3rd type, HFS isotropic constant and HFS anisotropy in the binding sites of the 2nd type), has the form:

$$\ln D_{12}^2 (x) = \frac{1}{2} \left( [x-\bar{x}_2]^T \lambda_2^{-1} [x-\bar{x}_2] - [x-\bar{x}_1]^T \lambda_1^{-1} [x-\bar{x}_1] \right) + \ln \sqrt{\frac{\det \lambda_2}{\det \lambda_1}} \,, \tag{12}$$

where

$\bar{x}_i$ is the column vector of mean values of tests in the i-th group of patients,
$\lambda_i^{-1}$ is the inverse matrix to the matrix of covariance of tests in the i-th group of patients,
$\det \lambda_i$ is the determinant of the covariance matrix of the i-th group of patients.

The column vector of test's values includes as its components the parameters of spin probe mobility in the above-mentioned sequence.

Parameters of quadratic discriminating function (12):

| Group of cancer patient (i = 1) | | | | Group of of patients without malignant tumours (i = 2) | | | |
|---|---|---|---|---|---|---|---|
| Vectors of mean values ($\mathbf{x}_i$): | | | | | | | |
| 0.5019 | | | | 0.5287 | | | |
| 14.798 | | | | 14.849 | | | |
| -0.1216 | | | | -0.1212 | | | |
| 0.0221 | | | | 0.01649 | | | |
| | | | | | | | |
| Inverse matrixes to the matrixes of covariances ($\lambda_i^{-1}$): | | | | | | | |
| 5898.8 | 4790.7 | -548390 | 1334.9 | 2743.1 | 6312.7 | -611219 | 24201 |
| 4790.7 | 3.875 | -4.52E+7 | 94853 | 6312.7 | 365086 | -4.305E+7 | 108964 |
| -548390 | -4.52E+7 | 5.288E+9 | -1.061E+7 | -611219 | -4.305E+7 | 5.102E+9 | -1.076E+7 |
| 1334.9 | 94853 | -1.061E+7 | 123682 | 24201 | 108964 | -1.076E+7 | 524402 |
| Determinants of covariance matrixes (det $\lambda_i$): | | | | | | | |
| 9.554E-21 | | | | 2.032E-22 | | | |

The decision rule:

According to $\mathbf{x}$ test data, the patient is attributed to cancer arm if $\ln D_{12}^2 (x) > 0$ and to the arm of persons without cancer disease if $\ln D_{12}^2 (x) < 0$.

Fig.4 presents as an example statistical distributions of values of discriminating functions obtained in the study of 212 patients with various cancer sites (stomach, esophagus, rectum, liver, lung, breast, prostate) and 87 persons without malignant neoplasms. For comparison, Table 4 demonstrates the data on diagnostic precision of the tests based on separate parameters of spin probe mobility, obtained in the same study.

Fig. 4: View test. Diagnostic sensitivity (Dse) = 0.93, Diagnostic specifity (DSp) = 0.089, diagnostic precision (Dp) = 0.91 _____ cancer patients _____ persons without malignant neoplasms

Table 4

| | Diagnostic precision of tests based on separate parameters of spin probe mobility, obtained in the study of 212 patients with various cancer sites (stomach, esophagus, rectum, liver, lung, breast, prostate) and 87 persons without malignant neoplasms | | | |
|---|---|---|---|---|
| | Number and name of the parameter | DSe | DSp | DP |
| 1. | Concentration, the 1st component | 66.7±11.1 | 84.6±7.1 | 75.6±9.3 |
| 2. | Concentration, the 2nd component | 72.2±10.6 | 61.5±9.5 | 66.9±10.1 |
| 3. | Isotropic HFS, the 1st component | 77.8±9.8 | 50.0±9.8 | 63.9±9.8 |
| 4. | Isotropic HFS, the 2nd component | 72.2±10.6 | 84.6±7.1 | 78.4±9.0 |
| 5. | HFS anisotropy, the 1st component | 83.3±8.8 | 65.4±9.3 | 74.4±9.1 |
| 6. | HFS anisotropy, the 2nd component | 72.2±10.6 | 88.5±6.3 | 80.3±8.7 |
| 7. | Width of high-field line, the 1st component | 50.0±11.8 | 73.1±8.7 | 61.5±10.4 |
| 8. | Width of central line, the 1st component | 77.8±9.8 | 80.8±7.7 | 79.3±8.8 |
| 9. | Width of low-field line, the 1st component | 88.9±7.4 | 34.6±9.3 | 61.8±8.4 |
| 10. | Width of high-field line, the 2nd component | 66.7±11.1 | 76.9±8.3 | 71.8±9.8 |
| 11. | Width of central line, the 2nd component | 55.6±11.7 | 84.6±7.1 | 70.1±9.7 |
| 12. | Width of low-field line, the 2nd component | 50.0±11.8 | 73.1±8.7 | 61.5±10.4 |
| 13. | g-factor anisotropy, the 2nd component | 88.9±7.4 | 61.5±9.5 | 75.2±8.5 |
| 14. | Isotropic g-factor, the 2nd component | 88.9±7.4 | 50.0±9.8 | 69.4±8.7 |
| 15. | Concentration, the 3rd component | 88.9±7.4 | 88.5±6.3 | 88.7±6.9 |

The presented data of the very extensive clinical studies confirm high precision (at a level of 90 to 95%) of cancer diagnosis according to the present invention based on interrelated variations in the parameters of spin probe mobility at specific sites of serum albumin (SA) binding.

The same data are corroboration of the presence of cancer-specific decrease in conformation mobility of SA molecules.

**Claims**

1. An in vitro method of diagnosing cancer based on electron-spin-resonance spectroscopy ESR comprising the steps of

   - incubation of a serum probe of a patient with spin probe solution
   - recording an ESR spectrum at a constant temperature under conversion into a digital form
   - evaluating the digitalised spectrum by comparing it with a model spectrum.

2. The method according to claim 1 wherein the evaluation is carried out with a model spectrum having a shape Im(H) which is obtained with the algorithm which reads as follows:

$$I_m(H) = \frac{\int\limits_{H-H_{mod}}^{H+H_{mod}} I_g(H_1)\sqrt{1-\left(\frac{H-H_1}{H_{mod}}\right)^2}\,dH_1}{\int\limits_{H-H_{mod}}^{H+H_{mod}}\sqrt{1-\left(\frac{H-H_1}{H_{mod}}\right)^2}\,dH_1},$$

wherein

$H_{mod}$ is the modulation peak value

$H_1$ is the peak value of the magnetic component of the microwave field.

3. The method according to claim 1 or 2 wherein a discriminating function is used which is a mathematical function integrating directed deviations in separate parameters.

4. The method according to claim 3 wherein the discriminating function is plotted by discriminating analysis, cluster or factor analysis, or by empirical method on the basis of analysis of the data obtained in clinical examinations.

5. The method according to claim 3 wherein the discriminating function is plotted by means of quadratic discriminating analysis.

6. The method according to claim 5 wherein the logarithm (ln) of the quadratic discriminating function for two compared groups of cancer patients with patients without malignant tumors, which includes 4 parameters of spin probe mobility, namely probe concentration at the binding sites of the 1st type, probe concentration at the binding sites of the 3rd type, HFS isotropic constant and HFS anisotropy in the binding sites of the 2nd type, has the following formula:

$$\ln D_{12}^2(x) = \frac{1}{2}\left([x-\bar{x}_2]^T \lambda_2^{-1}[x-\bar{x}_2] - [x-\bar{x}_1]^T \lambda_1^{-1}[x-\bar{x}_1]\right) + \ln\sqrt{\frac{\det\lambda_2}{\det\lambda_1}}, \tag{12}$$

where

$\bar{x}_i$ is the column vector of mean values of tests in the i-th group of patients,
$\lambda^{-1}_i$ is the inverse matrix to the matrix of covariance of tests in the i-th group of patients,
$\det\lambda_i$ is the determinant of the covariance matrix of the i-th group of patients.

7. The method according to claim 6 wherein the following decisive rule according to **x** test data is used:

the patient is attributed to a cancer group if $\ln D_{12}^2(x) > 0$,
and to the group of persons without cancer disease if $\ln D_{12}^2(x) < 0$.

$$\alpha = \frac{A}{B}$$

**Fig. 1**

2 model of spectrum

1 experimental spectrum

**Fig. 2**

Fig. 3

FIG. 4

European Patent Office

**EUROPEAN SEARCH REPORT**

Application Number

EP 98 81 0665

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 125 651 A (SPECIAL REFERENCE LAB INC ;JEOL LTD (JP)) 21 November 1984 * page 1, line 1 - page 1, line 6 * * page 3, line 19 - page 9, line 18; figures 4,7-13 * | 1,3,4 | G01R33/60 |
| X | EP 0 699 904 A (KUREHA CHEMICAL IND CO LTD ;TOKYO WOMEN S MEDICAL COLLEGE (JP)) 6 March 1996 * column 1, line 7 - column 2, line 48 * * column 5, line 50 - column 6, line 51 * * column 9, line 31 - column 10, line 14; figure 1 * | 1 | |
| A | HILTUNEN Y ET AL: "PROTON NUCLEAR MAGNETIC RESONANCE LINESHAPE STUDIES ON HUMAN BLOOD PLASMA LIPIDS FROM NEWBORN INFANTS, HEALTHY ADULTS, AND ADULTS WITH TUMORS" MAGNETIC RESONANCE IN MEDICINE, vol. 26, no. 1, 1 July 1992, pages 89-99, XP000280565 | 1 | |
| | | | TECHNICAL FIELDS SEARCHED (Int.Cl.6) G01R |
| A | US 5 765 562 A (LEUNBACH IB ET AL) 16 June 1998 * column 3, line 49 - column 9, line 46 * | 1,2 | |

The present search report has been drawn up for all claims

| Place of search | Date of completion of the search | Examiner |
|---|---|---|
| MUNICH | 29 December 1998 | Lersch, W |

## ANNEX TO THE EUROPEAN SEARCH REPORT
## ON EUROPEAN PATENT APPLICATION NO.

EP 98 81 0665

This annex lists the patent family members relating to the patent documents cited in the above-mentioned European search report.
The members are as contained in the European Patent Office EDP file on
The European Patent Office is in no way liable for these particulars which are merely given for the purpose of information.

29-12-1998

| Patent document cited in search report | | Publication date | Patent family member(s) | | Publication date |
|---|---|---|---|---|---|
| EP 0125651 | A | 21-11-1984 | JP | 1619182 C | 30-09-1991 |
| | | | JP | 2045151 B | 08-10-1990 |
| | | | JP | 60201255 A | 11-10-1985 |
| | | | JP | 1585973 C | 31-10-1990 |
| | | | JP | 2013270 B | 03-04-1990 |
| | | | JP | 59208460 A | 26-11-1984 |
| | | | JP | 1637179 C | 31-01-1992 |
| | | | JP | 3005551 B | 25-01-1991 |
| | | | JP | 60135765 A | 19-07-1985 |
| | | | US | 4696905 A | 29-09-1987 |
| EP 0699904 | A | 06-03-1996 | JP | 8070889 A | 19-03-1996 |
| | | | CA | 2157345 A | 03-03-1996 |
| US 5765562 | A | 16-06-1998 | AU | 6884796 A | 27-03-1997 |
| | | | CA | 2231405 A | 13-03-1997 |
| | | | CZ | 9800669 A | 15-07-1998 |
| | | | EP | 0871896 A | 21-10-1998 |
| | | | WO | 9709633 A | 13-03-1997 |
| | | | NO | 980965 A | 28-04-1998 |
| | | | PL | 325428 A | 20-07-1998 |

EPO FORM P0459

For more details about this annex : see Official Journal of the European Patent Office, No. 12/82